# EUROPEAN PATENT APPLICATION

(11) **EP 3 435 748 A1**
(43) Date of publication of application: **30.01.2019**
(21) Application number: 17772988.6
(22) Date of filing: 22.02.2017
(51) Int. Cl.: H05K 5/04, B29C 45/14, H04M 1/02

(54) **METALLIC SHELL HAVING CERAMIC PANEL AND PREPARATION METHOD AND USE THEREOF**

(30) Priority: 31.03.2016 CN 201610196378
(71) Applicant: BYD Company Limited, Shenzhen, Guangdong 518118 (CN)
(72) Inventor: REN, Peng, Shenzhen, Guangdong 518118 (CN); ZHU, Shuai, Shenzhen, Guangdong 518118 (CN); WANG, Haixia, Shenzhen, Guangdong 518118 (CN); MA, Lan, Shenzhen, Guangdong 518118 (CN); CHEN, Liang, Shenzhen, Guangdong 518118 (CN)
(74) Representative: Hoffmann Eitle
(86) International application number: PCT/CN2017/074448
(87) International publication number: WO 2017/166957

(57) **Abstract**

A metal housing having a ceramic panel and a manufacturing method and an application thereof are provided. The metal housing includes a ceramic panel, a metal frame, and a plastic layer. A periphery of the plastic layer is connected to at least a part of an inner side of the metal frame. The plastic layer has a concave portion. The ceramic panel covers the concave portion and is connected to the plastic layer.

## Description

### BACKGROUND

### Technical Field

The present invention relates to a housing and a manufacturing method and an application thereof, and specifically, to a metal housing having a ceramic panel and a manufacturing method thereof and an application of the housing as a housing of a communications device.

### Related Art

In a current manufacturing process of a housing of a communications device, a panel is generally bonded to a lower display component by using an adhesive, and then connected to a metal housing by using a clamp structure disposed on the display component. The panel and the metal housing are connected in such an assembling manner. Due to different machining precisions of sizes of different components in a machining process, there is a certain machining error between the panel and the metal housing, causing a relatively large gap or step between the panel and the metal housing after the two components are assembled. As a result, the appearance of the product is severely affected, and the strength and impact resistance of the housing are decreased.

### SUMMARY

A first objective of the present invention is to provide a metal housing having a ceramic panel. The metal housing connects a ceramic panel and a metal frame without a gap or a step by using a plastic layer, to ensure the smoothness of the metal housing in appearance and improve the strength and impact resistance of the metal housing.

A second objective of the present invention is to provide a manufacturing method of a metal housing having a ceramic panel. According to the manufacturing method of a metal housing having a ceramic panel in the present invention, the metal housing and a panel can be connected to each other by using an injection-molded plastic layer, the smoothness of the metal housing in appearance can be ensured, and the strength and impact resistance of the metal housing can be improved.

To achieve the foregoing objective, the present invention provides a metal housing having a ceramic panel. The metal housing includes a ceramic panel, a metal frame, and a plastic layer. A periphery of the plastic layer is connected to at least a part of an inner side of the metal frame, the plastic layer has a concave portion, and the ceramic panel covers the concave portion and is connected to the plastic layer.

Preferably, the metal frame, the ceramic panel, and the plastic layer are located in a same plane in appearance.

The present invention further provides a manufacturing method of a metal housing having a ceramic panel, where the manufacturing method includes the following steps:
(1) placing a ceramic panel and a metal frame into an injection molding mold, and separating a periphery of the ceramic panel from the metal frame by a certain gap; and
(2) forming a plastic layer by using an injection-molded resin composition.

The present invention further provides an application of the metal housing having a ceramic panel as a housing of a communications device.

Based on the foregoing technical solutions, the metal housing in the present invention can be smooth in appearance and have desirable strength and impact resistance.

Some additional aspects and advantages of the present invention are provided in the following description, and some become obvious in the following description or can be learned of by practicing the present invention.

### BRIEF DESCRIPTION OF THE DRAWINGS

Embodiments are described with reference to the accompanying drawings below to make the foregoing and/or additional aspects and advantages of the present invention more obvious and comprehensible.
FIG. 1 is a schematic structural diagram of an outer side surface of a metal housing having a ceramic panel according to the present invention;
FIG. 2 is a schematic structural diagram of an inner side surface of a metal housing having a ceramic panel according to the present invention;
FIG. 3 is a schematic structural diagram of a ceramic panel;
FIG. 4 is a schematic structural diagram of a metal frame;
FIG. 5 is a schematic structural diagram of a plastic layer according to an implementation of the present invention; and
FIG. 6 is a schematic structural diagram of a plastic layer according to another implementation of the present invention.

### Description of Reference Numerals

1: Ceramic panel 2: Metal frame 3: Plastic layer
4: Stretch-release adhesive structure 5: Fixing structure 6: Opening used for an antenna assembly structure
7: Opening used for a photosensitive device assembly structure 8: Opening used for a sound pickup hole of a microphone
9: Opening used for a camera assembly structure 10: Opening used for a battery compartment assembly structure
11: Opening used for an injection molding positioning hole 12: Injection molding sprue

### DETAILED DESCRIPTION

The following describes embodiments of the present invention in detail. Examples of the embodiments are shown in the accompanying drawings. Same or similar numerals always represent same or similar elements or elements having same or similar functions. The embodiments described below with reference to the accompanying drawings are exemplary and are intended to explain the present invention, and cannot be understood as a limitation on the present invention.

In the description of the present invention, it should be understood that, orientations or position relationships indicated by terms such as "center", "longitudinal", "transverse", "length", "width", "thickness", "up", "down", "front", "back", "left", "right", "vertical", "horizontal", "top", "bottom", "inner", "outer", "clockwise", "counterclockwise", "axial", "radial", and "circumferential" are orientations or position relationship shown based on the accompanying drawings, and are merely used for describing the present invention and simplifying the description, rather than indicating or implying that the apparatus or element should have a particular orientation or be constructed and operated in a particular orientation, and therefore, should not be construed as a limitation on the present invention.

In addition, the terms "first" and "second" are merely used for description purposes, but cannot be understood as indicating or denoting relative importance, or implicating or specifying the quantity of the indicated technical features. Therefore, features defined by "first" and "second" may explicitly or implicitly include at least one feature. In the descriptions of the present invention, "a plurality of' means at least two, for example, two or three, unless it is otherwise specified.

In the present invention, it should be noted that unless otherwise clearly specified and limited, the terms "mounted", "connected", "connection", and "fixed" should be understood in a broad sense. For example, a connection may be a fixed connection, a detachable connection, or an integral connection; may be a mechanical connection or an electrical connection; may be a direct connection or an indirect connection by means of an intermediate medium; or may be internal communication between two elements or interaction relationship between two elements, unless otherwise clearly limited. A person of ordinary skill in the art may understand specific meanings of the terms in the present invention according to specific conditions.

In the present invention, unless otherwise clearly specified and limited, that a first feature is "above" or "below" a second feature may be that the first and the second features are in contact with each other directly, or the first and the second features are in contact with each other indirectly by using an intermediate medium. Moreover, that the first feature is "above", "over", and "on" the second feature may be that the first feature is right above the second feature or at an inclined top of the second feature, or may merely indicate that the horizontal height of the first feature is higher than that of the second feature. That the first feature is "below", "under", and "beneath" the second feature may be that the first feature is right below the second feature or at an inclined bottom of the second feature, or may merely indicate that the horizontal height of the first feature is lower than that of the second feature.

The endpoints of ranges and any value disclosed in this specification are not limited to ranges or values of a precision, and the ranges or values should be understood as including values close to the ranges or values. For a number range, endpoints of ranges, endpoints of ranges and a separate endpoint, and separate endpoints may be combined with each other to obtain a new or a plurality of new number ranges, and the number ranges should be considered as specifically disclosed in this specification.

In the present invention, an inner surface of a metal housing having a ceramic panel is defined as a surface, facing an inner part of a product, of the metal housing when the metal housing is used as a housing of the product. It may be understood that an outer surface of the metal housing is defined as a surface, facing the outside, of the metal housing when the metal housing is used as the housing of the product. In addition, the foregoing definitions are also applicable to inner and outer surfaces of a metal frame and a ceramic panel that are used for manufacturing the metal housing.

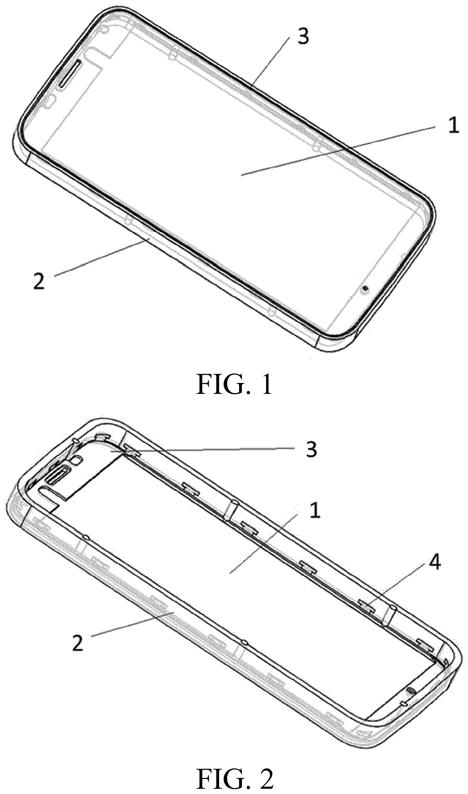

As shown in FIG. 1 and FIG. 2, a metal housing having a ceramic panel provided in the present invention includes a ceramic panel 1, a metal frame 2, and a plastic layer 3, where a periphery of the plastic layer 3 is connected to at least a part of an inner side of the metal frame 2, the plastic layer 3 has a concave portion, and the ceramic panel 1 covers the concave portion and is connected to the plastic layer 3.

In the present invention, "a periphery of the plastic layer 3 is connected to at least a part of an inner side of the metal frame 2" means that the entire periphery of the plastic layer 3 is connected to the inner side of the metal frame 2, and a connected part is an area of at least a part of the inner side of the metal frame 2 in the width direction of the metal frame 2.

In the present invention, the material of the metal frame 2 may be various metals that are conventionally used for frames in the art, and may be, for example, an aluminum alloy, stainless steel, a magnesium alloy, or a titanium alloy.

In the present invention, the material of the ceramic panel 1 may be ceramic that is conventionally used in the art, and preferably, may be one or more of zirconium oxide, aluminum oxide, and silicon oxide. Such a ceramic panel is commercially available, and may be, for example, a zirconium oxide ceramic sheet from Shenzhen Hard Precision Ceramic Co. Ltd.

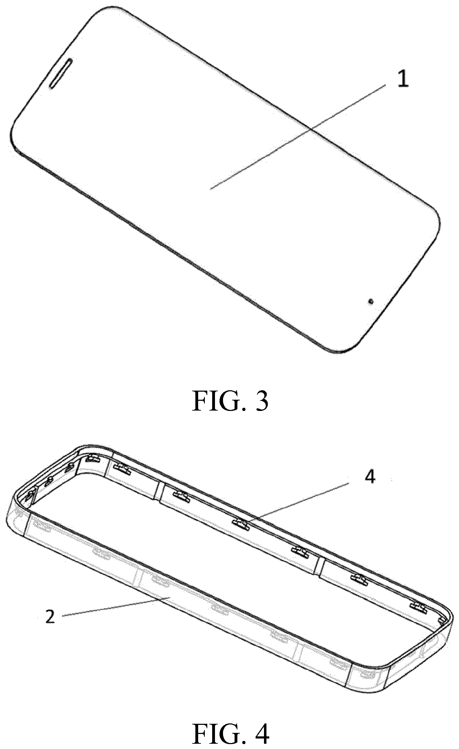

According to the embodiments of the present invention, the shape of the ceramic panel 1 may be selected according to an actual requirement. In addition, as shown in FIG. 3, the ceramic panel 1 may further be provided with an opening as required. The opening may be an opening and the like used for a camera assembly, and is preferably the same as an opening on the plastic layer described below.

According to the embodiments of the present invention, the thickness of the ceramic panel 1 may be selected according to a communications device to which the ceramic panel 1 is applied. For example, when the ceramic panel 1 is used as a housing of a mobile phone, the thickness of the ceramic panel 1 is preferably 0.2 mm to 2 mm, and more preferably 0.2 mm to 0.8 mm.

According to the present invention, the metal frame may be obtained by means of squeezing, punching, forging or CNC machining. Methods and conditions of each process described above need to be described. The methods and conditions of squeezing, punching, forging, and CNC machining are well known in the art and are not repeatedly described herein.

In the present invention, the material of the plastic layer may be plastic that is conventionally selected in the art, and may be resin preferably. The resin may be one or more selected from polyethylene, polypropylene, polyacetal, polystyrene, modified polyphenylene oxide, polyethylene terephthalate, polybutylene terephthalate, polyethylene naphthalate, polyphenylene sulfide, polyimide, polyamideimide, polyetherimide, polysulfone, polyether sulphone, polyether ketone, polyether ether magnesium, polycarbonate, polyamide, and an acrylonitrile butadiene styrene copolymer.

To further improve the mechanical strength of the obtained metal housing, more preferably, the material of the plastic layer is a mixture of the resin and glass fiber. Further preferably, in the foregoing mixture, the resin is one selected from of polyphenylene sulfide, polycarbonate, and polyamide; and the content of the glass fiber is 1% to 50% by weight by using the weight of the mixture as a basis.

According to the embodiments of the present invention, there is a certain horizontal distance between a periphery of the ceramic panel 1 and the metal frame 2. The horizontal distance is a horizontal distance between the periphery of the ceramic panel 1 and an inner side surface of the metal frame 2 adjacent to the ceramic panel 1. To further improve the strength and impact resistance of the metal housing, horizontal distances are equal in circumferential directions of an outer side surface of the ceramic panel 1.

According to the present invention, the horizontal distance between the periphery of the ceramic panel 1 and the metal frame 2 is less than 2 mm. Preferably, the horizontal distance between the periphery of the ceramic panel 1 and the metal frame 2 is less than 1 mm. More preferably, the horizontal distance between the periphery of the ceramic panel 1 and the metal frame 2 is less than 0.8 mm. Further preferably, the horizontal distance between the periphery of the ceramic panel 1 and the metal frame 2 is 0.3 mm to 0.6 mm. The horizontal distance between the periphery of the ceramic panel 1 and the metal frame 2 falls within the foregoing ranges, so that the ceramic panel 1 and the metal housing 2 are connected without a gap by using the plastic layer. Moreover, the strength and impact resistance of the metal housing can be improved. Particularly, when the horizontal distance between the periphery of the ceramic panel 1 and the metal frame 2 is 0.3 mm to 0.6 mm, the plastic layer is invisible in appearance and an optimal appearance effect is achieved.

According to the embodiments of the present invention, to ensure the smoothness of the metal housing in appearance, preferably, the metal frame 2, the ceramic panel 1, and the plastic layer 3 are located in a same plane in appearance. The metal frame 2, the ceramic panel 1, and the plastic layer 3 are located in a same plane in appearance, so that the metal housing can connect the ceramic panel 1 and the metal frame 2 without a gap or a step by using the plastic layer 3, the smoothness of the metal housing in appearance can be ensured, and the strength and impact resistance of the metal housing can be improved.

According to the embodiments of the present invention, the thickness of the plastic layer 3 is not particularly limited, and may be, for example, 0.1 mm to 2 mm, and may be preferably, 0.3 mm to 0.6 mm. In the present invention, the thickness of the plastic layer 3 is the thickness of the plastic layer 3 between the periphery of the ceramic panel 1 and the metal frame 2.

According to the embodiments of the present invention, the plastic layer 3 may further be provided with an opening as required.

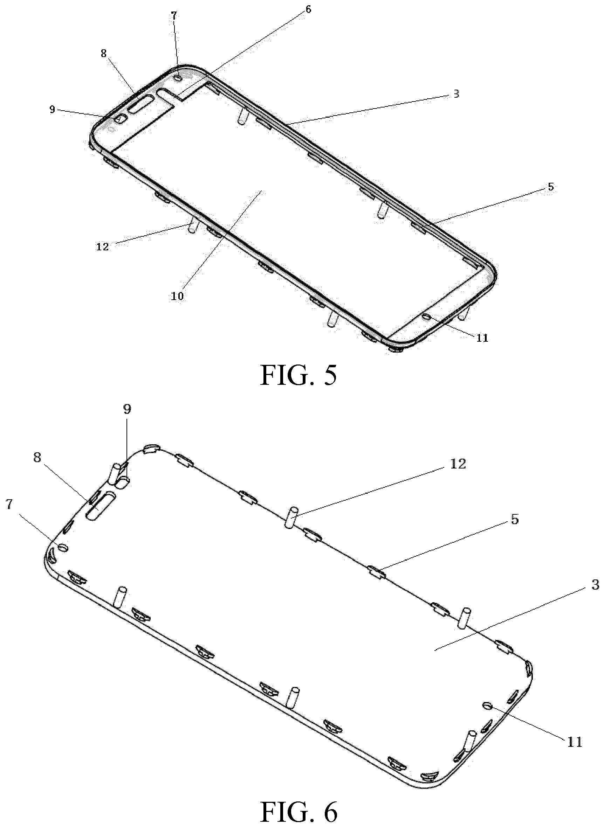

In a preferred implementation of the present invention, as shown in FIG. 5, the plastic layer 3 may further be provided with an opening as required. The opening may be, for example, an opening 6 used for an antenna assembly structure, an opening 7 used for a photosensitive device assembly structure, an opening 8 used for a sound pickup hole of a microphone, an opening 9 used for a camera assembly structure, an opening 10 used for a battery compartment assembly structure, and an opening 11 used for an injection molding positioning hole.

In another preferred implementation of the present invention, as shown in 6, the plastic layer 3 may further be provided with an opening as required. The opening may be, for example, an opening 7 used for a photosensitive device assembly structure, an opening 8 used for a sound pickup hole of a microphone, an opening 9 used for a camera assembly structure, and an opening 11 used for an injection molding positioning hole.

In addition, a plurality of injection molding sprues 12 may further be disposed on the plastic layer 3 of the present invention, and the injection molding sprues 12 are formed at positions at which raw materials are poured during injection molding. The number of the injection molding sprues 12 may be appropriately selected as required by a person skilled in the art.

According to the embodiments of the present invention, as shown in FIG. 4 and FIG. 5, to further improve the strength and impact resistance of the metal housing, preferably, more than one stretch-release adhesive structure 4 is formed at a joint of the inner side of the metal frame 2 and the plastic layer 3, and a fixing structure matching the stretch-release adhesive structure is formed on the plastic layer 3 corresponding to the stretch-release adhesive structure 4. Preferably, the stretch-release adhesive structure is an inverted T-shaped dovetail groove structure.

In a particularly preferred implementation of the present invention, the metal housing is formed by performing injection molding on the ceramic panel and the metal frame.

According to the embodiments of the present invention, to improve the tightness of the joint between the ceramic panel and the plastic layer, and further improve the strength and impact resistance of the metal housing, preferably, an adhesive layer is provided between the ceramic panel and the plastic layer.

According to the embodiments of the present invention, to improve the tightness of the joint between the ceramic panel and the plastic layer, and further improve the strength and impact resistance of the metal housing, preferably, the adhesive layer is provided at the joint of the inner side of the metal frame and the plastic layer, or a nanoscale pore is provided at the joint of the inner side of the metal frame and the plastic layer.

In the present invention, the adhesive layer is obtained by solidifying an adhesive. A type of the adhesive is not particularly limited and is well known in the art. For example, the adhesive may be the NoriPress SMK adhesive from the German Proell company.

The thickness of the adhesive layer is not particularly limited, and is preferably, 10 µm to 100 µm.

According to the embodiments of the present invention, an aperture of the nanoscale pore may be 10 nm to 2000 nm, and is preferably, 10 nm to 1000 nm.

The present invention further provides a manufacturing method of a metal housing having a ceramic panel, where the manufacturing method includes the following steps:
(1) placing a ceramic panel and a metal frame into an injection molding mold, and separating a periphery of the ceramic panel from the metal frame by a certain gap; and
(2) forming a plastic layer by using an injection-molded resin composition.

According to the embodiments of the present invention, in step (1), the ceramic panel and the metal frame are placed into the injection molding mold, a uniform-sized gap is maintained between the ceramic panel and the metal frame, upper surfaces of the ceramic panel and the metal frame are flush with each other in the mold, and then the plastic layer is formed by means of injection molding in step (2).

According to the embodiments of the present invention, the material of the ceramic panel may be ceramic that is conventionally used in the art, and preferably, may be one or more of zirconium oxide, aluminum oxide, and silicon oxide. Such a ceramic panel is commercially available, and may be, for example, a zirconium oxide ceramic sheet from Shenzhen Hard Precision Ceramic Co. Ltd.

According to the embodiments of the present invention, the shape of the ceramic panel may be selected according to an actual requirement. In addition, as shown in FIG. 3, the ceramic panel may further be provided with an opening as required. The opening may be, for example, an opening used for a camera assembly.

According to the embodiments of the present invention, the thickness of the ceramic panel may be selected according to a communications device to which the ceramic panel is applied. For example, when the ceramic panel 1 is used as a housing of a mobile phone, the thickness of the ceramic panel 1 is preferably 0.2 mm to 2 mm, and more preferably 0.2 mm to 0.8 mm.

According to the embodiments of the present invention, the metal frame may be obtained by means of squeezing, punching, forging or CNC machining. The methods and conditions of squeezing, punching, forging, and CNC machining are well known in the art and are not repeatedly described herein.

According to the embodiments of the present invention, in step (1), the width of the gap is less than 2 mm, preferably less than 1 mm, more preferably less than 0.8 mm, and further preferably between 0.3 mm to 0.6 mm.

Preferably, by means of the injection molding, the metal frame, the ceramic panel, and the plastic layer are located in a same plane in appearance.

Resin in the resin composition used during the injection molding may be resin that is conventionally used in the art, and may be one or more selected from polyethylene, polypropylene, polyacetal, polystyrene, modified polyphenylene oxide, polyethylene terephthalate, polybutylene terephthalate, polyethylene naphthalate, polyphenylene sulfide, polyimide, polyamideimide, polyetherimide, polysulfone, polyether sulphone, polyether ketone, polyether ether magnesium, polycarbonate, polyamide, and an acrylonitrile butadiene styrene copolymer.

To further improve mechanical strength of the obtained metal housing, preferably, the resin composition used during the injection molding is a mixture of the resin and glass fiber. More preferably, in the foregoing mixture, the resin is one selected from of polyphenylene sulfide, polycarbonate, and polyamide. The content of the glass fiber is 1% to 50% by weight by using the weight of the mixture as a basis.

According to the embodiments of the present invention, the conditions of the injection molding are not particularly limited, and may be conditions that are conventionally used in the art. For example, the conditions of the injection molding include a mold temperature of 20°C to 60°C, a nozzle temperature of 240°C to 300°C, a dwell time of 1 s to 5 s, an injection pressure of 5 MPa to 10 MPa, an injection time of 1 s to 2 s, and a cooling time of 10s to 20s.

According to the embodiments of the present invention, the thickness of the plastic layer obtained by means of injection molding is not particularly limited, and may be, for example, 0.1 mm to 2 mm, and may be preferably, 0.3 mm to 0.6 mm. In the present invention, the thickness of the plastic layer is the thickness of the plastic layer between the periphery of the ceramic panel and the metal frame.

According to the embodiments of the present invention, to improve the tightness of the joint between the ceramic panel and the plastic layer, and further improve the strength and impact resistance of the metal housing, preferably, before step (1) is performed, one or more of the following steps are performed:
step A: forming a solidified adhesive layer on an inner surface of the ceramic panel;
step B: forming a solidified adhesive layer on an inner side surface of the metal frame;
step C: forming more than one stretch-release adhesive structure on an inner side of the metal frame; and
step D: forming a nanoscale pore on the inner side of the metal frame.

In step A, the solidified adhesive layer may be obtained by printing an adhesive on an inner surface of the ceramic panel and solidifying the adhesive. Types of the adhesive and methods for printing and solidifying the adhesive are well known in the art. For example, the adhesive is the NoriPress SMK adhesive from the German Proell company; the printing may be screen printing; and the condition of the solidification is performing drying for 30 minutes to 150 minutes in an environment of 80°C to 90°C.

In step B, the solidified adhesive layer may be obtained by dispensing the adhesive on the inner side of the metal frame and solidifying the adhesive. Types of the adhesive and methods for dispensing and solidifying the adhesive are well known in the art. For example, the adhesive is the NoriPress SMK adhesive from the German Proell company; and the condition of the solidification is performing drying for 30 minutes to 150 minutes in an environment of 80°C to 90°C.

In step C, the stretch-release adhesive structure may be obtained by means of CNC machining on the inner side of the metal frame. The stretch-release adhesive structure may be an inverted T-shaped dovetail groove; and conditions of the CNC machining may be performing machining by using a T-shaped knife at a machining speed of 8000 revolutions per minute.

In step D, the following process is preferably used to form the nanoscale pore. An aperture of the formed pore may be, for example, 10 nm to 1000 nm. A specific process is as follows:
S1. Perform anodizing on a pre-treated metal frame to obtain a metal frame whose surface has an oxide film layer with nano pores. Anodizing is an anodizing technology well known by a person skilled in the art. Preferably, the present invention includes the following steps: a pre-treated metal frame used as an anode is placed into sulfuric acid having a concentration of 10 wt% to 30 wt%, and electrolyzed for 1 min to 40 min at a temperature of 10°C to 30°C and a voltage of 10 V to 20 V, to obtain a metal frame having an oxide film layer whose thickness is 1 µm to 10 µm. An anodizing device such as an anodizing tank well known in the art is used as a device for anodizing. Preferably, the thickness of the oxide film layer prepared by means of anodizing is 1 µm to 5 µm, and an aperture of a nano pore in the oxide film layer is 10 nm to 100 nm, further preferably, 20 nm to 80 nm, further, 20 nm to 60 nm. The nano pore has a thickness of 0.5 µm to 5 µm, so that the nano pore has a stronger bonding force with the resin.
S2. Immerse the metal frame obtained in step S1 that has an oxide film layer with nano pores into a composite buffer solution whose pH is 10 to 13, and form corrosion holes on an outer surface of the oxide film layer to obtain the metal frame on which surface treatment has been performed. The composite buffer solution may be a mixed solution of carbonate and bicarbonate, or a mixed solution of phosphate and monohydrogen phosphate. The composite buffer solution in the present invention may alternatively be a mixed solution of soluble hydrogen phosphate and soluble alkali, and nanoscale corrosion holes obtained by means of corrosion is preferably selected. The soluble hydrogen phosphate is preferably dihydrogen phosphate, the soluble alkali is strong alkali, apertures of reconstructed corrosion holes may reach 200 nm to 2000 nm or even 600 nm to 2000 nm, and the depth of the corrosion holes may reach 0.5 mm to 9.5 mm. The corrosion holes are in communication with the nano pores to the greatest extent, holes are reconstructed by such means of corrosion, and in a subsequent molding process, a resin composition may more easily enter pores on the surface of an aluminum alloy during injection molding, so as to be better bound to the aluminum alloy after a resin layer is formed. Preferably, the dihydrogen phosphate is one or more selected from sodium dihydrogen phosphate, potassium dihydrogen phosphate, ammonium dihydrogen phosphate, and aluminum dihydrogen phosphate, and the soluble alkali is selected from sodium hydroxide and/or potassium hydroxide. By using the foregoing preferred dihydrogen phosphate and soluble alkali, the corrosion holes can be uniformly distributed on the surface of the oxide film layer. In addition, the apertures are uniform and hole structures are desirable, so that the resin layer and the metal frame can have better bonding performance and a higher anti-tensile strength, and an aluminum alloy composite can be better integrally bonded. The mass percent concentration of dihydrogen phosphate is 50% to 99%, and is further preferably 60% to 99%. The mass percent concentration of soluble alkali is 1% to 50%, and is further preferably 1% to 40%. The metal frame having the oxide film layer with nano pores is immersed into the composite buffer solution, and the aluminum alloy is repeatedly immersed into the composite buffer solution. The metal frame is immersed for 1 min to 60 min each time, and cleaned with deionized water after each time of immersion. Immersion may be performed twice to 10 times. Cleaning may be that the metal frame is cleaned for 1 min to 5 min in a rinsing bath, or placed in a rinsing bath for 1 min to 5 min.

The pre-treatment is a pre-treatment process that is commonly performed on a metal surface by a person skilled in the art and that generally includes performing mechanical grinding or polishing to remove obvious foreign matter on the surface, and then performing degreasing and cleaning on processing oil attached on the metal surface. Preferably, the pre-treatment includes polishing the metal surface, and may be, for example, polishing the metal surface by using a 100-mesh to 400-mesh sandpaper or by placing the metal frame into a polishing machine, so that the metal frame generates nanoscale pores. Then, steps such as unoiling, first rinsing, alkaline etching, second rinsing, neutralization, and third rinsing are sequentially performed, and the metal is cleaned in ultrasound waves for 0.5 h to 2 h by using various solvents commonly used by a person skilled in the art, to remove oil on the metal surface; and then the metal is placed in aqueous acid/alkaline solution, and the metal surface is rinsed in a condition of ultrasound waves. The solvent may be ethanol or acetone. The aqueous acid/alkaline solution is various types of aqueous acid/alkaline solutions that are commonly used by a person skilled in the art, and may be, for example, hydrochloric acid, sulfuric acid, sodium hydroxide, and potassium hydroxide. In the present invention, preferably, after the metal is unoiled by using absolute ethanol, the metal is cleaned with water and wiped clean, and then immersed into 40 g/L-sodium hydroxide solution at a temperature of 40°C to 80°C for alkaline etching. After 1 min to 5 min, the metal is taken out, rinsed clean with deionized water, neutralized with 10% HNO₃ to 30% HNO₃ to remove residual alkaline solution, and then rinsed clean with deionized water. After the preferred pre-treatment, nanoscale pores may be formed on the surface of the metal frame, and the diameter of the pores is 1 mm to 10 mm.

In a preferred implementation of the present invention, before step (1) is performed, step A and step C are performed.

In another preferred implementation of the present invention, before step (1) is performed, step A and step B are performed.

In another preferred implementation of the present invention, before step (1) is performed, step A and step D are performed.

According to the embodiments of the present invention, during the formation of the plastic layer, the plastic layer may further be provided with an opening as required. For example, as shown in FIG. 5, an opening 6 used for an antenna assembly structure, an opening 7 used for a photosensitive device assembly structure, an opening 8 used for a sound pickup hole of a microphone, an opening 9 used for a camera assembly structure, an opening 10 used for a battery compartment assembly structure, and an opening 11 used for an injection molding positioning hole may be formed.

In a preferred implementation of the present invention, during the formation of the plastic layer, an opening 6 used for an antenna assembly structure, an opening 7 used for a photosensitive device assembly structure, an opening 8 used for a sound pickup hole of a microphone, an opening 9 used for a camera assembly structure, an opening 10 used for a battery compartment assembly structure, and an opening 11 used for an injection molding positioning hole are formed.

In a preferred implementation of the present invention, during the formation of the plastic layer, an opening 7 used for a photosensitive device assembly structure, an opening 8 used for a sound pickup hole of a microphone, an opening 9 used for a camera assembly structure, and an opening 11 used for an injection molding positioning hole are formed.

The present invention further provides a metal housing having a ceramic panel manufactured according to the manufacturing method described above.

The present invention further provides an application of the metal housing having a ceramic panel as a housing of a communications device.

In the present invention, the communications device may be, for example, a mobile phone, a tablet computer, a notebook computer, a router, or a Bluetooth headset.

The following describes the present invention with reference to specific embodiments. It should be noted that the embodiments are merely used for description, rather than limiting the present invention in any manner.

### Embodiment 1

This embodiment is used for describing the metal housing having a ceramic panel and the manufacturing method thereof that are provided in the present invention.
1) Obtain a metal frame by means of CNC machining, where the metal frame has a length of 127 mm, a width of 65 mm, and a thickness of 8.2 mm, the material of the metal frame is an aluminum alloy, and the thickness of the metal material is 1.5 mm.
2) A solidified adhesive layer (where a used adhesive is the NoriPress SMK adhesive purchased from the German Proell company, and the thickness of the adhesive layer is 0.05 mm after solidification) covers an inner surface of a ceramic panel (where a zirconium oxide ceramic sheet that is purchased from Shenzhen Hard Precision Ceramic Co. Ltd and has a length of 123 mm, a width of 61 mm, and a thickness of 0.5 mm) after printing and drying are performed on the inner surface.
3) A stretch-release adhesive structure (where the stretch-release adhesive structure is an inverted T-shaped dovetail groove structure, and a distance between two adjacent stretch-release adhesive structures is 20 mm) is formed on an inner side of the metal frame by means of CNC machining. Conditions of the CNC machining are performing machining by using a T-shaped knife at a machining speed of 8000 revolutions/minute.
4) The ceramic panel and the metal frame are placed in an injection molding mold (where the mold has protrusions for forming an opening 6 used for an antenna assembly structure, an opening 7 used for a photosensitive device assembly structure, an opening 8 used for a sound pickup hole of a microphone, an opening 9 used for a camera assembly structure, an opening 10 used for a battery compartment assembly structure, and an opening 11 used for an injection molding positioning hole shown in FIG. 5), a uniform-sized gap is maintained between the ceramic panel and the metal frame, upper surfaces of the ceramic panel and the metal frame are flush with each other in the mold, and then the metal housing having a ceramic panel is obtained by means of injection molding. The gap is 0.5 mm wide. The material for the injection molding is polyamide. Conditions of the injection molding are a mold temperature of 20°C, a nozzle temperature of 240°C, a dwell time of 3 s, an injection pressure of 8 MPa, an injection time of 1.2 s, and a cooling time of 15 s.

The obtained metal housing consists of the ceramic panel 1 having the structure shown in FIG. 3, the metal frame 2 having the structure shown in FIG. 4, and the plastic layer 3 having the structure shown in FIG. 5. The ceramic panel 1 and the metal frame 2 are connected to each other by using the plastic layer 3. The ceramic panel 1, the metal frame 2, and the plastic layer 3 are located in a same plane in appearance. An inner side surface of the ceramic panel 1 is connected to the plastic layer 3 by using the adhesive layer. The metal frame 2 matches and is connected to the fixing structure 5 of the plastic layer 3 by using a stretch-release adhesive structure 4. The metal housing having a ceramic panel is smooth in appearance and has desirable strength and impact resistance, and components of the metal housing are closely connected.

### Embodiment 2

This embodiment is used for describing the metal housing having a ceramic panel and the manufacturing method thereof that are provided in the present invention.
1) Obtain a metal frame by means of CNC machining, where the metal frame has a length of 127 mm, a width of 65 mm, and a thickness of 8.2 mm, the material of the metal frame is an aluminum alloy, and the thickness of the metal material is 1.5 mm.
2) A solidified adhesive layer (where a used adhesive is the NoriPress SMK adhesive purchased from the German Proell company, and the thickness of the adhesive layer is 0.05 mm after solidification) covers an inner surface of a ceramic panel (where a zirconium oxide ceramic sheet that is purchased from Shenzhen Hard Precision Ceramic Co. Ltd and has a length of 123.4 mm, a width of 61.4 mm, and a thickness of 0.5 mm) after printing and drying are performed on the inner surface.
3) A solidified adhesive layer (where a used adhesive is the NoriPress SMK adhesive purchased from the German Proell company, and the thickness of the adhesive layer is 0.05 mm after solidification) covers an inner side surface of the metal frame after dispensing and drying are performed on the inner side surface.
4) The ceramic panel and the metal frame are placed in an injection molding mold (where the mold has protrusions for forming an opening 6 used for an antenna assembly structure, an opening 7 used for a photosensitive device assembly structure, an opening 8 used for a sound pickup hole of a microphone, an opening 9 used for a camera assembly structure, an opening 10 used for a battery compartment assembly structure, and an opening 11 used for an injection molding positioning hole shown in FIG. 5), a uniform-sized gap is maintained between the ceramic panel and the metal frame, upper surfaces of the ceramic panel and the metal frame are flush with each other in the mold, and then the metal housing having a ceramic panel is obtained by means of injection molding. The gap is 0.3 mm wide. The material for the injection molding is polyamide. Conditions of the injection molding are a mold temperature of 20°C, a nozzle temperature of 260°C, a dwell time of 3 s, an injection pressure of 10 MPa, an injection time of 1.2 s, and a cooling time of 15 s.

The obtained metal housing consists of the ceramic panel, the metal frame, and the plastic layer 3 shown in FIG. 5. The ceramic panel and the metal frame are connected to each other by using the plastic layer 3 formed by means of injection molding. The ceramic panel, the metal frame, and the plastic layer 3 are located in a same plane in appearance. An inner side surface of the ceramic panel is connected to the plastic layer 3 by using the adhesive layer. An inner side surface of the metal frame is connected to the plastic layer 3 by using the adhesive layer. The metal housing having a ceramic panel is smooth in appearance and has desirable strength and impact resistance, and components of the metal housing are closely connected.

### Embodiment 3

This embodiment is used for describing the metal housing having a ceramic panel and the manufacturing method thereof that are provided in the present invention.
1) Obtain a metal frame by means of CNC machining, where the metal frame has a length of 127 mm, a width of 65 mm, and a thickness of 8.2 mm, the material of the metal frame is an aluminum alloy, and the thickness of the metal material is 1.5 mm.
2) A solidified adhesive layer (where a used adhesive is the NoriPress SMK adhesive purchased from the German Proell company, and the thickness of the adhesive layer is 0.05 mm after solidification) covers an inner surface of a ceramic panel (where a zirconium oxide ceramic sheet that is purchased from Shenzhen Hard Precision Ceramic Co. Ltd and has a length of 122.8 mm, a width of 60.8 mm, and a thickness of 0.5 mm) after printing and drying are performed on the inner surface.
3) Clean the metal frame with absolute ethanol, immerse the metal frame in a 2 wt% sodium hydroxide solution, and after 2 min, take out the metal frame and rinse the metal frame with deionized water, to obtain a pre-treated metal frame; place the pre-treated metal frame as an anode into an anodizing tank with H₂SO₄ having a concentration of approximately 20 wt%, electrolyze the metal frame for 5 min at a voltage of 15 V and dry the metal frame; prepare an aqueous solution (pH=11.8) of 100 ml in a beaker with 5 g of sodium dihydrogen phosphate and 1 g of sodium hydroxide, and under the condition of 20°C, immerse the obtained metal frame in the solution for 3 min, then take out the metal frame and immerse it into a beaker with water for 1 min. The foregoing process is performed five times. At the last time of immersion in water, the pre-treated metal frame is dried, to obtain a metal frame whose inner side surface has pores having an aperture of 600 nm to 1000 nm.
4) The ceramic panel and the metal frame are placed in an injection molding mold (where the mold has protrusions for forming an opening 7 used for a photosensitive device assembly structure, an opening 8 used for a sound pickup hole of a microphone, an opening 9 used for a camera assembly structure, and an opening 11 used for an injection molding positioning hole shown in FIG. 6), a uniform-sized gap is maintained between the ceramic panel and the metal frame, upper surfaces of the ceramic panel and the metal frame are flush with each other in the mold, and then the metal housing having a ceramic panel is obtained by means of injection molding. The gap is 0.6 mm wide. The material for the injection molding is polyamide. Conditions of the injection molding are a mold temperature of 20°C, a nozzle temperature of 240°C, a dwell time of 3 s, an injection pressure of 8 MPa, an injection time of 1.2 s, and a cooling time of 15 s.

The obtained metal housing consists of the ceramic panel, the metal frame, and the plastic layer 3 shown in FIG. 6. The ceramic panel and the metal frame are connected to each other by using the plastic layer 3 formed by means of injection molding. The ceramic panel, the metal frame, and the plastic layer 3 are located in a same plane in appearance. An inner side surface of the ceramic panel is connected to the plastic layer 3 by using the adhesive layer. The metal frame is connected to the plastic layer 3 by using a nanoscale pore. The metal housing having a ceramic panel is smooth in appearance and has desirable strength and impact resistance, and components of the metal housing are closely connected.

### Test case 1

The metal housings obtained in Embodiments 1 to 3 are tested by using a universal tensile testing machine. In a testing method, the metal frame is fixed, and an increasingly growing thrust is applied to the back of ceramic, to obtain a maximum thrust value when the ceramic is separated from the metal. An average maximum thrust of the metal housing obtained in Embodiment 1 is 723 N (where 10 metal housings are tested), an average maximum thrust of the metal housing obtained in Embodiment 2 is 725 N (where 10 metal housings are tested), and an average maximum thrust of the metal housing obtained in Embodiment 3 is 728 N (where 10 metal housings are tested).

Although preferred implementations of the present invention have been described in detail above with reference to the accompanying drawings, the present invention is not limited to specific details in the foregoing implementations. Various simple variations can be made to the technical solutions of the present invention within the scope of the technical idea of the present invention, and such simple variations all fall within the protection scope of the present invention.

It should be further noted that the specific technical features described in the foregoing specific implementations can be combined in any appropriate manner provided that no conflict occurs. To avoid unnecessary repetition, various possible combination manners are not described in the present invention.

In addition, various different implementations of the present invention may also be combined arbitrarily. Such combinations shall also be considered as the content disclosed in the present invention provided that these combinations do not depart from the concept of the present invention.

In the descriptions of this specification, the descriptions of a reference term such as "an embodiment", "some embodiments", "an example", "a specific example", or "some examples" refer to that specific features, structures, materials or characteristics described with reference to this embodiment or example are included in at least one embodiment or example of the present invention. In this specification, schematic descriptions of the foregoing terms are not necessarily provided for a same embodiment or example. Moreover, the described specific features, structures, materials or characteristics may be combined in an appropriate form in any one or more embodiments or examples. In addition, in cases that do not contradict each other, a person skilled in the art may combine different embodiments or examples described in this specification and features in different embodiments or examples.

Although the embodiments of the present invention are shown and described above, it may be understood that the embodiments are exemplary and cannot be construed as limitations on the present invention, and a person of ordinary skill in the art may make changes, modifications, replacements, and variations to the embodiments within the scope of the present invention.

## Claims

1. A metal housing having a ceramic panel, comprising a ceramic panel, a metal frame, and a plastic layer, wherein a periphery of the plastic layer is connected to at least a part of an inner side of the metal frame, the plastic layer has a concave portion, and the ceramic panel covers the concave portion and is connected to the plastic layer.

2. The metal housing according to claim 1, wherein a horizontal distance between a periphery of the ceramic panel and the metal frame is less than 2 mm.

3. The metal housing according to claim 1 or 2, wherein the horizontal distance between the periphery of the ceramic panel and the metal frame is less than 1 mm.

4. The metal housing according to any one of claims 1 to 3, wherein the horizontal distance between the periphery of the ceramic panel and the metal frame is less than 0.8 mm.

5. The metal housing according to any one of claims 1 to 4, wherein the horizontal distance between the periphery of the ceramic panel and the metal frame is 0.3 mm to 0.6 mm.

6. The metal housing according to any one of claims 1 to 5, wherein the metal frame, the ceramic panel, and the plastic layer are located in a same plane in appearance.

7. The metal housing according to any one of claims 1 to 6, wherein the thickness of the plastic layer is 0.1 mm to 2 mm.

8. The metal housing according to any one of claims 1 to 7, wherein the thickness of the ceramic panel is 0.2 mm to 2 mm.

9. The metal housing according to any one of claims 1 to 8, wherein more than one stretch-release adhesive structure is formed at a joint of the inner side of the metal frame and the plastic layer, and a fixing structure matching the stretch-release adhesive structure is formed on the plastic layer corresponding to the stretch-release adhesive structure.

10. The metal housing according to any one of claims 1 to 9, wherein the stretch-release adhesive structure is an inverted T-shaped dovetail groove structure.

11. The metal housing according to any one of claims 1 to 10, wherein the metal housing is formed by performing integral injection molding on the ceramic panel and the metal frame.

12. The metal housing according to any one of claims 1 to 11, wherein an adhesive layer is provided between the ceramic panel and the plastic layer.

13. The metal housing according to any one of claims 1 to 12, wherein the adhesive layer is provided at the joint of the inner side of the metal frame and the plastic layer.

14. The metal housing according to any one of claims 1 to 13, wherein a nanoscale pore is provided at the joint of the inner side of the metal frame and the plastic layer.

15. The metal housing according to any one of claims 1 to 14, wherein the plastic layer has an opening.

16. The metal housing according to any one of claims 1 to 15, wherein the metal housing is a housing of a mobile phone.

17. A manufacturing method of a metal housing having a ceramic panel, wherein the manufacturing method comprises the following steps:
(1) placing a ceramic panel and a metal frame into an injection molding mold, and separating a periphery of the ceramic panel from the metal frame by a certain gap; and
(2) forming a plastic layer by using an injection-molded resin composition.

18. The method according to claim 17, wherein in step (1), the width of the gap is less than 2 mm.

19. The method according to claim 17 or 18, wherein in step (1), the width of the gap is less than 1 mm.

20. The method according to any one of claims 17 to 19, wherein in step (1), the width of the gap is less than 0.8 mm.

21. The method according to any one of claims 17 to 20, wherein in step (1), the width of the gap is 0.3 mm to 0.6 mm.

22. The method according to any one of claims 17 to 21, wherein by means of injection molding, the metal frame, the ceramic panel, and the injection-molded plastic layer are located in a same plane in appearance.

23. The method according to any one of claims 17 to 22, wherein the thickness of the plastic layer is 0.1 mm to 2 mm

24. The method according to any one of claims 17 to 23, wherein the thickness of the ceramic panel is 0.2 mm to 2 mm.

25. The method according to any one of claims 17 to 24, wherein conditions of the injection molding comprises: a mold temperature of 20°C to 60°C, a nozzle temperature of 240°C to 300°C, a dwell time of 1 s to 5 s, an injection pressure of 5 MPa to 10 MPa, an injection time of 1 s to 2 s, and a cooling time of 10 s to 20 s.

26. The method according to any one of claims 17 to 25, wherein before step (1), one or more of step A to step D are performed:
step A: forming a solidified adhesive layer on an inner surface of the ceramic panel;
step B: forming a solidified adhesive layer on an inner side surface of the metal frame;
step C: forming more than one stretch-release adhesive structure on an inner side of the metal frame; and
step D: forming a nanoscale pore on the inner side of the metal frame.

27. The method according to any one of claims 17 to 26, wherein the metal housing is a housing of a mobile phone.

28. A metal housing, wherein the metal housing is manufactured by using the method according to any one of claims 17 to 27.

29. An application of the metal housing having a ceramic panel according to any one of claims 1 to 16 and 28 as a housing of a communications device.
